# EUROPEAN PATENT APPLICATION

(11) **EP 0 649 176 A2**
(43) Date of publication of application: **19.04.1995**
(21) Application number: 94307477.3
(22) Date of filing: 12.10.1994
(51) Int. Cl.: H01L 29/772, H01L 27/02, H01L 29/72

(54) **Insulated-gate bipolar transistor**

(30) Priority: 14.10.1993 JP 256197/93; 25.02.1994 JP 27074/94
(71) Applicant: FUJI ELECTRIC CO. LTD., Kawasaki 210 (JP)
(72) Inventor: Otsuki, Masahito, Kawasaki-ku, Kawasaki 210 (JP); Obinata, Shigeyuki, Kawasaki-ku, Kawasaki 210 (JP); Yano, Yukio, Kawasaki-ku, Kawasaki 210 (JP)
(74) Representative: Topley, Paul

(57) **Abstract**

An insulated-gate bipolar transistor is provided which is capable of detecting an overcurrent in a short time accurately while maintaining the ratio of the main current to the detection current constant under various operating circumstances and which, when combined with an externally connected overcurrent protection circuit, can reliably protect the device against overcurrent. An insulated-gate bipolar transistor has a semiconductor substrate (5) on which a plurality of IGBT cells (6) are packed, preferably in striped form. Current-detecting cells (6b) are disposed on parts of the substrate adjacent to the main cells (6a). The current-detecting cell (6b) are equipped with an emitter electrode (7b) which is isolated from the emitter electrodes (7a) of the main cells and connected with an external overcurrent protection circuit. When an accident such as load short circuit takes place, the overcurrent is quickly and accurately detected by the current-detecting cells (6b). The externally connected protection circuit (3, 4) controls the gates. Thus, the main current is limited to a low current which is less than the short circuit withstand capability of the IGBT. In this way, overcurrent protection is provided.

## Description

The present invention relates to an insulated-gate bipolar transistor (IGBT) acting as a power device applicable to an inverter device or the like.

An insulated-gate bipolar transistor (hereinafter referred to as an "IGBT") is a voltage-driven semiconductor switching device which can be turned on and off at a high speed and which has a relatively low ON voltage. Insulated-gate bipolar transistors have enjoyed wide acceptance in power electronics applications.

In IGBT-output type inverter devices and similar devices, when an electric motor is started, or if an accident such as a load short circuit or an arm short circuit takes place, an overcurrent flows through the IGBT. Thus, quite severe requirements for withstanding high voltages and large currents are imposed on the IGBT. An important requirement is an ability to withstand a short-circuit.

Inverter apparatus generally includes a protection circuit which detects a short-circuit and cuts off the power supply, but there is usually an interval of from 10 to 20 µsec between detection of the short-circuit and shutdown. The IGBT is however required not to be destroyed in this interval.

Accordingly, an overcurrent protection system is generally adopted to prevent the IGBT device from being destroyed when a short circuit takes place until the power supply is cut off by a protector device for an inverter. Such an overcurrent protection system, which is separate from the aforementioned protector device, quickly detects an overcurrent flowing through the IGBT, and a signal based on the overcurrent detection is applied to the gate which controls the current flowing through the IGBT, reducing the current to below the withstand capability of the IGBT before the power supply is cut off, whereby the current is suppressed to within the short-circuit tolerance of the device.

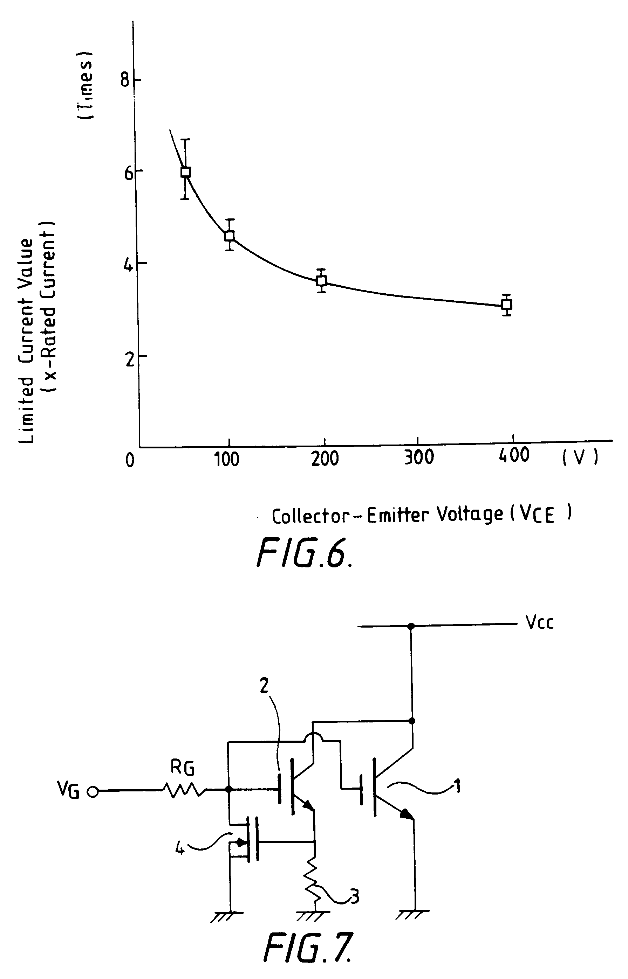

Figure 7 shows a conventional overcurrent protection circuit for to an IGBT. In the Figure, indicated by 1 is a main IGBT. A separate auxiliary current-detection element (IGBT) 2 is connected in parallel with the main IGBT 1 and used to detect an electrical current. A current-detecting resistor 3 is connected in series with the current-detecting IGBT 2. A switching element 4 (MOSFET) is connected with a gate-driving circuit for both the IGBTs 1 and 2, and is turned on and off according to a voltage developed across the current-detecting resistor 3.

In this arrangement, when an accident such as a load short circuit takes place, an overcurrent flows through the main and auxiliary IGBTs 1 and 2 and as a result a voltage is developed across the current-detecting resistor 3 which exceeds the threshold voltage of the switching device 4, and the switching device 4 is turned on. This lowers the gate voltage of the main IGBT 1 and the gate voltage of the current-detecting IGBT 2, thus restricting the currents through the IGBTs 1 and 2 to low values. In this case, the main current flowing through the main IGBT to be protected can be reduced to below the short-circuit withstand capability of the IGBT device by setting the resistance value of the current-detecting resistor 3 and the threshold voltage of the switching device 4 appropriately.

In particular, short-circuit accidents in an inverter include such events as an arm short-circuit, a series short-circuit, earthing (grounding), etc. In order to detect the overcurrent flowing through the main IGBT 1 quickly and accurately and to perform a reliable protection operation, it is very important that the ratio of the main current flowing through the main IGBT 1 to the detection current flowing through the IGBT 2 be maintained at a constant value irrespective of the type of short-circuit occurring. Moreover, the collector-emitter voltage V_{CE} applied to the IGBT to be protected is expected to vary in the different short-circuit modes in load short-circuits of the inverter. The above-described overcurrent protection circuit must then limit the overcurrent to below the short-circuit withstand capability of the IGBT so that the limited current does not depend on or vary with the collector-emitter voltage V_{CE}. Where the overcurrent protection circuit including the current-detecting element IGBT 2 is built as a circuit external to the main IGBT 1 to be protected, the following problems arise:

If the main IGBT 1 and the current-detecting IGBT 2 are made as separate devices, it is quite difficult to secure a proportional relation between the operating characteristics of the IGBTs 1 and 2. In particular, where the collector-emitter voltage V_{CE} of the IGBT varies as described above, the current ratio between the main and auxiliary IGBT elements 1 and 2 also varies, and thus the value of the limited current also varies greatly. In consequence, it is difficult to secure stable operation for overcurrent protection.

In view of the foregoing, the present invention has been made with the objective to provide an insulated-gate bipolar transistor with an overcurrent limiting function which can reliably protect the device against overcurrent by maintaining the ratio of the main current to the detection current constant under various operating circumstances and suppressing variation of the limited current in dependance on collector-emitter voltage and its variation.

In order to achieve the above-described object, the present invention provides an insulated-gate bipolar transistor having a semiconductor substrate on which a number of main cells are packed, the transistor being characterised in that a number of the cells are used as current-detecting cells, and at least one emitter electrode is formed on or in said current-detecting cell and connected with an external overcurrent protection circuit, said emitter electrode being isolated from the emitter electrodes of said main cells.

In the above-described structure, the current-detecting cell or cells is or are preferably formed adjacent to the main cells in an outermost portion of an active region of the semiconductor substrate. Alternatively, it is possible that at least a part of the current-detecting cell is formed in a position surrounded by active regions of the main cells.

To suppress the voltage dependance and reduce variation of the limited value of the overcurrent, the pitch of the cells is preferably not more than 50 µm.

In the foregoing structure, the electrical current flowing through the IGBT is detected by a voltage across the current-detecting resistor of the protection circuit which is externally connected with the emitter electrode of the current-detecting cell, via the emitter electrode, the cell being formed on the semiconductor substrate on which the main cells are also formed. If an overcurrent flows due to a load short circuit, the protection circuit operates to limit the main current flowing in the main cells to below the short-circuit withstand capability, thus preventing the cells from being destroyed. Since the current-detecting cells are disposed adjacent to the main cells within the same semiconductor substrate the carrier distribution in the main cell region is substantially the same as the carrier distribution in the current-detecting cell area. Consequently, the overcurrent can be detected in a quite short time while maintaining the ratio of the main current to the detection current constant. Specifically, where at least a part of the current-detecting cell is positioned in a location surrounded by the active regions of the main cells with the cells arranged in striped layout and the pitch of the cells being not more than 50 µm, the accuracy with which the current is detected is further enhanced. In such an arrangement, the limited current value can be brought below the short-circuit withstand capability of the IGBT with little variation and dependance on the power supply voltage. The current-detecting IGBT cell and the main IGBT cells can be fabricated at the same time on the same semiconductor substrate by a common manufacturing process.

Embodiments of the invention are hereinafter described with reference to the drawings, in which:
Figure 1 is a schematic of an insulated-gate bipolar transistor according to an example of the present invention, and in which (a) is a plan view of an IGBT chip and (b) is a cross-sectional view showing the structure of an IGBT cell formed in the chip;
Figure 2 is an enlarged view of a current-detecting portion showing an example of application of Figure 1;
Figure 3 is a waveform diagram illustrating operation, the diagram being obtained when a protection circuit is connected with the structure of Figure 1 and the flowing current is restricted under a load-shorted condition;
Figure 4 is a diagram showing the characteristics of a protection operation showing the relation between limited current and power voltage, for comparing examples of Figures 1 and 2; and
Figure 5 is a diagram of an overcurrent protection circuit for an IGBT.

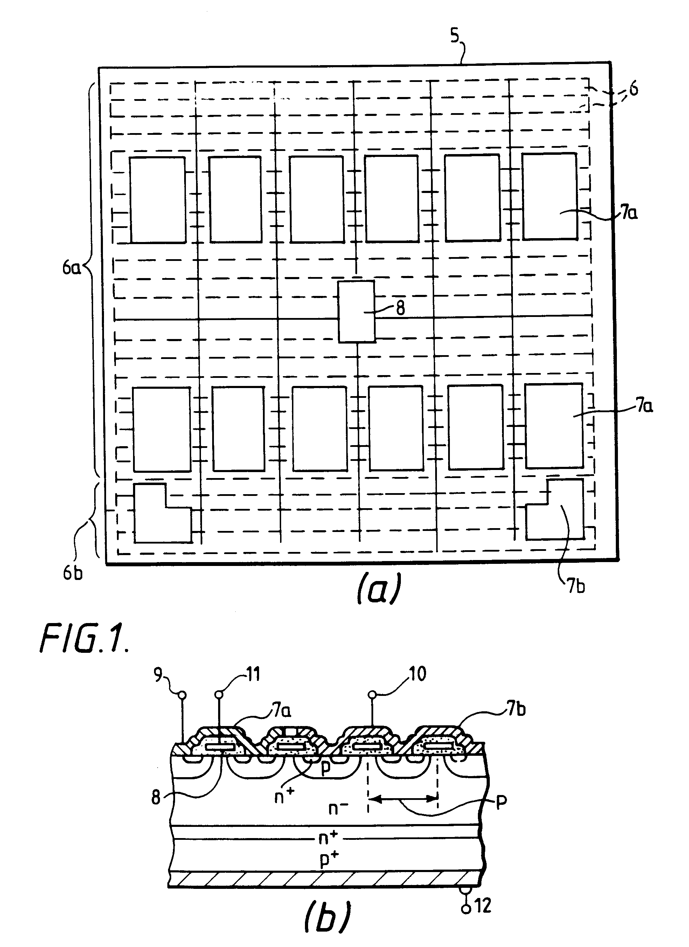

Figure 1(a) is a plan view of an IGBT chip, and Figure 1(b) is a cross-sectional view showing a cell structure formed on the chip.

In the Figures, a semiconductor substrate 5 has a multiplicity of IGBT cells 6 packed thereon in striped form. Most of these cells are used as main cells 6a. Some of the IGBT cells formed in the active region located in the outermost portion of the semiconductor substrate 5 are used as current-detecting cells 6b. Current-detecting emitter electrodes 7b corresponding to the current-detecting cells 6b are formed on the chip top surface of the semiconductor substrate 5 and are isolated from the main emitter electrodes 7a corresponding to the main cells 6a. The gate electrode 8 for all the IGBT cells 6 is formed in the centre of the chip. In Figure 1(b), a main emitter terminal 9 is connected to the emitter terminals 7a of the cells 6a, a current-detecting emitter terminal 10 is connected to the emitter terminals 7b of the sensing cells 6b, a gate terminal 11 is connected to gate terminal 8, and a collector terminal 12 is connected to a collector electrode formed on the underside of the substrate.

The emitter electrode 7b is connected to the current-detecting resistor 3 of the overcurrent protection circuit shown in Figure 7 via a wire. The resistor 3 of the overcurrent protection circuit and an auxiliary element 4 may be formed on the semiconductor substrate 5 surrounding the gate electrode 8, or may be on a separate chip from the semiconductor substrate 5 described above, and are incorporated within the package of this transistor module.

The operation of the above overcurrent protection circuit for the IGBT is similar to the operation described previously in connection with Figure 7; an overcurrent is detected by the current-detecting resistor 3 of the protection circuit (Figure 7) through the emitter electrodes 7b of the current-detecting cells 6b, which are formed adjacent to the main cells 6a on the same semiconductor substrate 5. Since the carrier distribution around the current-detecting cells 6b is substantially the same as the carrier distribution in the main cells 6a, a limited current value of the main current can be reduced to below the short-circuit withstand capability of the IGBT in a very short time by accurately detecting the overcurrent while maintaining the ratio of the main current in cells 6a to the detection current in cells 6b constant.

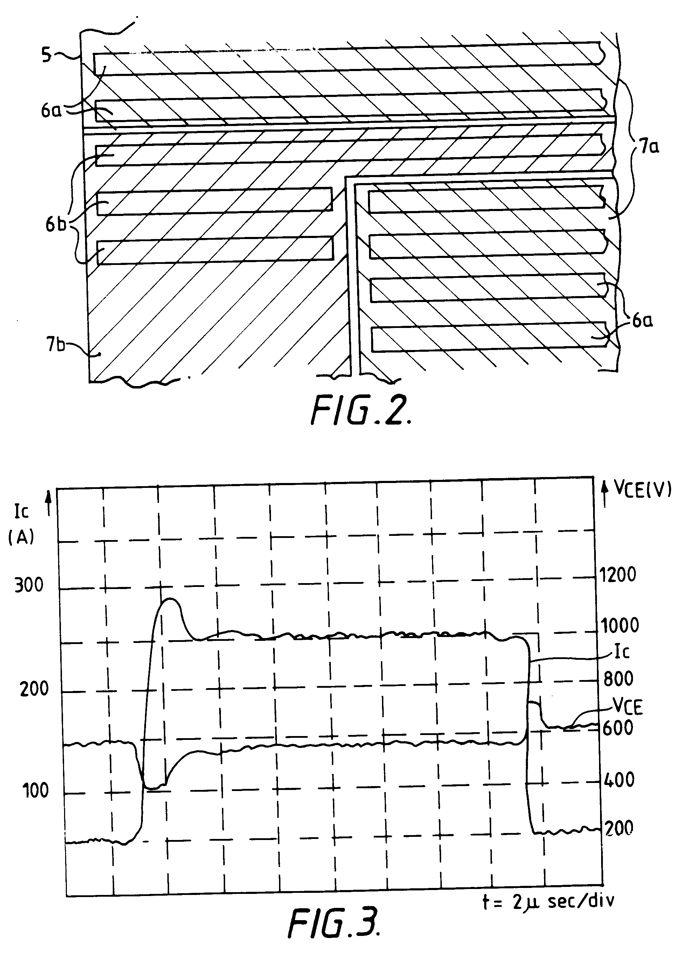

Figure 3 shows an operation waveform diagram illustrating the operational variation with time of a main current Ic, and the voltage V_{CE} developed between the collector and the emitter, obtained by an experiment in which a protection circuit comprising a detection resistor 3 and a switching element 4 of Figure 7 is externally connected with the sensing cells of the IGBT (having a breakdown voltage of the order of 600 V and a rated current of 100 A) of the configuration of Figure 1. The power supply voltage V_{CC} was set at 400 V. As can be seen from this waveform diagram, the collector current value I_{c} of the main current Ic flowing through the IGBT is reduced in several microseconds to a value of 250 A which is within the short-circuit withstand capability. In this way, the device is protected against a short circuit.

Figure 2 is an enlarged view of the chip showing a modified form of the current-detecting cells 6b of the embodiment of Figure 1. In this example, some of the current-detecting cells 6b are extended into locations surrounded on three sides by the active regions of main cells 6a. In this arrangement, the carrier distribution around the current-detecting cells 6b is made closer to the carrier distribution in the main cells 6a than is achieved with the arrangement of Figure 1. This enhances the current detection accuracy and permits reliable overcurrent protection.

The overcurrent protecting function of the above scheme was evaluated by examining the voltage dependance of the limited current value at a short-circuit with respect to the test samples of the IGBTs of Figures 1 and 2. As a result, it has been found that the limited current value (indicated by the multiplication factor of the rated current Ic) tends to vary inversely with the collector-emitter voltage V_{CE} as shown in Figure 6. For example, a short-circuit test was conducted with test samples of IGBTs having a 70 µm cell pitch P formed on the semiconductor substrate (see Figure 1 (b)) under various power supply voltages. The test has confirmed that the limited current value in a range of low collector-emitter voltage V_{CE} of up to 100 V is more than two times larger than when the collector-emitter voltage V_{CE} is 400 V, and that the variation of the limited current value is more remarkable in the low-voltage range.

The above collector-emitter voltage dependance and the variation of the limited current value are considered to be caused by a variation of the potential distribution in the IGBT elements which depends on the magnitude of the applied voltage (power supply voltage) and varies the current flowing through the emitters of the sensing cells. A computer simulation analysis performed with the applied voltage set at 100 V and at 400 V showed that the distortion and variation of equipotential surfaces of the internal potential are larger when the applied voltage is 100 V than when it is 400 V.

Since the collector-emitter voltage V_{CE} of the IGBT in the inverter apparatus varies with the short-circuit mode at load short-circuit, the above-described voltage dependance and variation of the limited current value are unfavourable for the overcurrent protecting operation.

Observing the internal potential distribution of the semiconductor substrate, however, the voltage dependance and variation of the limited current value would be improved if the equipotential surfaces of the internal potential could be made flatter irrespective of the application voltage. As one of the approaches, it was investigated how the potential distribution in the element varies with the cell pitch of the IGBT. It has been found that the distortion of equipotential surfaces of the internal potential distribution is reduced, i.e., the equipotential surfaces are made flatter, by decreasing the cell pitch between the cells lined up on the semiconductor substrate in a striped manner and, the resultant the collector-emitter voltage dependance and variation of the limited current value in the overcurrent protecting operation can be minimised.

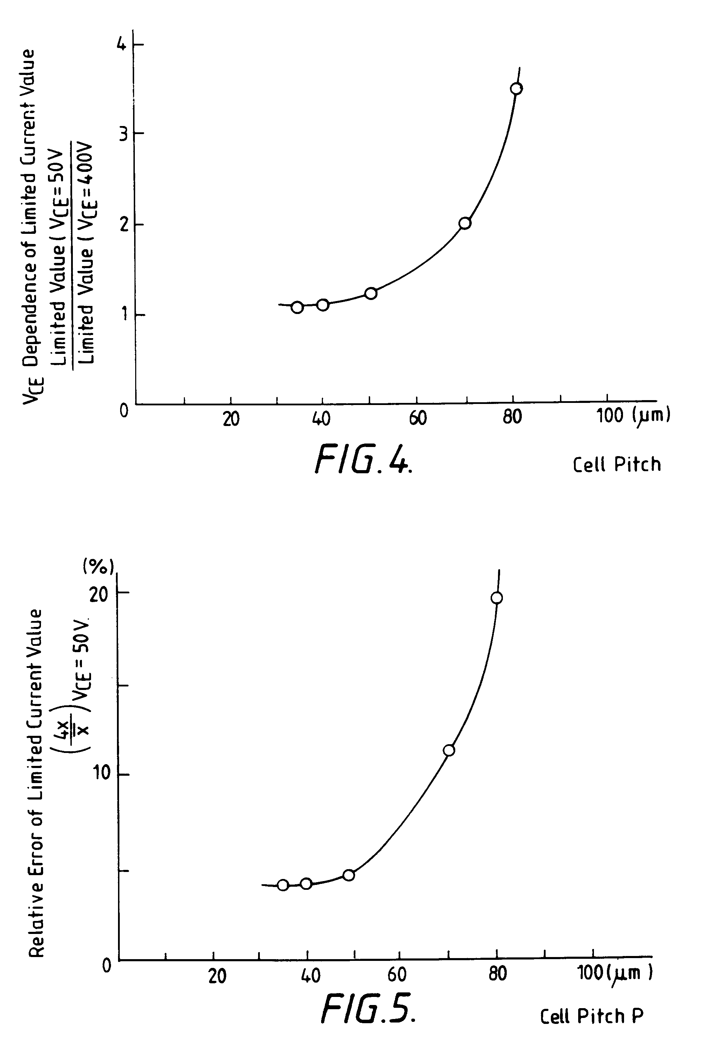

Figures 4 and 5 show firstly a relationship between the cell pitch and the collector-emitter voltage (V_{CE}) dependance of the limited current value, and secondly a relationship between the cell pitch and the relative error (variation) of the limited current value for V_{CE} = 50 V. As is apparent from these Figures, the voltage dependance and variation of the limited current value are improved as the cell pitch P decreases, and the degrees of those improvements tend to almost converge when the cell pitch P is not more than 50 µm. Therefore, by setting the cell pith P to not more than 50 µm for both the main cells 1 and the sensing cells 2 of Figures 1 and 2 in designing and manufacturing IGBTs having the current detecting function for overcurrent protection, superior characteristics can be obtained as to an overcurrent limiting function with little collector-emitter voltage dependance and little variation.

As described thus far, in the present invention, in an insulated-gate bipolar transistor comprising a number of cells formed on a semiconductor substrate in an integrated manner, part of the cells are used as current detection sensing cells, and an emitter electrode to be connected to an overcurrent protection circuit is formed in an area of the sensing cells so as to be separated from an emitter electrode of the main cells. The sensing cells enable highly accurate detection of an overcurrent caused by an accident such as a load short-circuit in an inverter apparatus. This makes it possible to provide an insulated-gate bipolar transistor having an overcurrent limiting function which enables a reliable overcurrent protecting operation by reducing the limited current value to below the short-circuit withstand capability in combination with the overcurrent protection circuit.

The current detection accuracy is further improved and the collector-emitter voltage dependance and variation of the limited current value can further be reduced by forming the current detection sensing cells so as to be surrounded by the active regions of the main cells on the same substrate and by setting the cell pitch to not more than 50 µm. Further, since the main cells and the sensing cells can be formed and integrated on a semiconductor substrate in the same manufacturing process, the cost can be reduced from the conventional case in which the main element and the auxiliary element are manufactured as separate elements.

## Claims

1. An insulated-gate bipolar transistor having a semiconductor substrate on which main cells are packed, said insulated-gate bipolar transistor comprising:
a cell formed on a part of said semiconductor substrate and used for detection of an electrical current; and
an emitter electrode formed on or in said current-detecting cell and connected with an external overcurrent protection circuit, said emitter electrode being isolated from emitter electrodes of said main cells.

2. An insulated-gate bipolar transistor of claim 1, wherein said current-detecting cell is formed adjacent to the main cells in an outermost portion of an active region of the semiconductor substrate.

3. An insulated-gate bipolar transistor of claim 1, wherein at least a part of the current-detecting cell is formed in a position surrounded by active regions of the main cells.

4. An insulated-gate bipolar transistor of any of claims 1 to 3, wherein the cell pitch on the semiconductor substrate is not more than 50 µm.
